# EUROPEAN PATENT APPLICATION

(11) **EP 4 787 648 A1**
(43) Date of publication of application: **05.08.2026**
(21) Application number: 26151122.4
(22) Date of filing: 09.01.2026
(51) Int. Cl.: H02J 1/08

(54) **MEDIUM VOLTAGE MODULAR RACK SYSTEM**

(30) Priority: 01.02.2025 US 202519043434
(71) Applicant: Microsoft Technology Licensing, LLC, Redmond, WA 98052 (US)
(72) Inventor: NASR AZADANI, EHSAN, Redmond, 98052 (US); HEATH, SCOT EDWARD, Redmond, 98052 (US); MAJD, AFSHIN, Redmond, 98052 (US); JOCHIM, JAYSON MICHAEL, Redmond, 98052 (US); OLARIU, LAURENTIU, Redmond, 98052 (US)
(74) Representative: CMS Cameron McKenna Nabarro Olswang LLP

(57) **Abstract**

A medium voltage, modular rack system includes: an IT (Information Technology) rack configured to house a plurality of compute resources; a power panel rack comprising a plurality of power connectors and configured to operatively couple the compute resources to a low voltage DC power source; an energy storage rack comprising one or more energy storage devices, wherein each of the energy storage devices is configured to store energy from and provide energy to the low voltage DC power source; a power conversion rack comprising power conversion devices configured to convert a medium voltage power source to the low voltage DC source; and a medium voltage rack configured to receive a medium voltage AC source and a medium voltage DC source.

## Description

### BACKGROUND

Datacenters contain IT (Information Technology) infrastructure, often housed in racks, that includes compute, storage, networking, and other devices. Need for compute, storage, and associated networking devices is increasing rapidly as applications such as artificial intelligence and cloud computing increasingly utilize such resources. As such, the number of datacenters is increasing and the density of IT infrastructure within datacenters is increasing. With increased density of IT infrastructure within a datacenter, power demand of each datacenter is also increasing.

In conventional datacenters, power is provided to racks through an electrical distribution path that begins at a power station that includes one or more generators. The generators produce medium voltage AC (Alternating Current) power. Various standards may define ranges of voltage that are considered extra-low, low, medium, high, extra-high, and ultra-high in the context of power transmission. For example, ANSI (American National Standards Institute) establishes nominal voltage ratings for 60 HZ electric power systems over 100V in which high voltage is defined as 115 kV to 230kV, extra-high voltage is defined as 345 kV to 765 kV, and ultra-high voltage is defined as above 1,100 KV.

The medium voltage AC power generated at the power station is stepped up by a power transformer to a high voltage AC (or extra-high or ultra-high voltage AC) for transmission via a transmission network to one or more substations. Transformers at the substations step the voltage down to medium voltage AC and distribute the medium voltage AC power to distributions substations. Transformers at the distribution substations step-down the AC power to a low voltage AC (and/or extra-low voltage AC) and provide the low voltage AC power to endpoints such as commercial buildings, industrial complexes, residential buildings, and the like. Within an endpoints like a datacenter, the low voltage AC power is often converted to DC (Direct Current) power at or near IT racks for use by the components of those racks.

Low voltage electricity is carried at higher currents to maintain the same or similar power that medium voltage provides when carried at lower currents. The higher the current, the more electrical wiring (often copper wiring) is required. Such copper wiring is relatively costly and requires significant physical infrastructure. In addition, low voltage electricity carried at higher currents tends to result in less efficient power transmission than medium voltage electricity carried at lower currents. As datacenters increase power demand with high density systems and high-power consuming workloads, the required amount of copper wiring within a datacenter's electrical distribution system will grow as well without a change to the power distribution path.

### SUMMARY

Described in this specification are modular rack systems configured for medium voltage according to various embodiments are described herein. The example medium voltage rack systems described herein are configured to receive, at the rack, medium voltage power in contrast to conventional systems that receive low voltage power. By moving the medium voltage to the rack itself rather than to the datacenter as a whole, the requirements for copper wiring throughout the datacenter can be reduced.

A medium voltage modular rack system configured in accordance with embodiments of the present disclosure includes an IT rack configured to house a plurality of compute resources, a power panel rack comprising a plurality of power connectors and configured to operatively couple the compute resources to a low voltage DC power source, an energy storage rack comprising one or more energy storage devices, where each of the energy storage devices is configured to store energy from and provide energy to the low voltage DC power source, a power conversion rack comprising power conversion devices configured to convert a medium voltage power source to the low voltage DC source, and a medium voltage rack configured to receive a medium voltage AC source and/or a medium voltage DC source.

Various apparatus for administering operations of a modular rack system for grid interaction in accordance with embodiments of the present disclosure are also described herein. Such an apparatus includes one or more processing devices and one or more memory devices operatively coupled to the processing devices. The processing devices are configured to: modify one or more operating parameters of the modular rack system for interactive grid controls.

Various apparatus for administering operations of a modular rack system for grid interaction in accordance with embodiments of the present disclosure are also described herein. Such an apparatus includes one or more processing devices and one or more memory devices operatively coupled to the processing devices. The processing devices are configured to modify one or more operating parameters of the modular rack system for interactive grid controls. The modular rack system includes an IT rack housing a plurality of compute resources, a power panel rack comprising a plurality of power connectors operatively coupling the compute resources to a low voltage DC power source, a power conversion rack comprising power conversion devices configured to convert a medium voltage power source to a low voltage DC source, and a medium voltage rack configured to receive a medium voltage AC source and a medium voltage DC source.

Various methods for administering operations of a modular rack system for grid interaction are also disclosed. Such methods include receiving one or more requests form an interactive grid device, receiving telemetry from one or more devices of the modular rack system, and modifying one or more operating parameters of the modular rack system for interactive grid control based on the telemetry and the one or more requests. The modular rack system includes an IT rack housing a plurality of compute resources, a power panel rack comprising a plurality of power connectors operatively coupling the compute resources to a low voltage DC power source, a power conversion rack comprising power conversion devices configured to convert a medium voltage power source to a low voltage DC source, and a medium voltage rack configured to receive a medium voltage AC source and a medium voltage DC source.

### BRIEF DESCRIPTION OF DRAWINGS

FIG. 1 illustrates a block diagram of an example datacenter that includes a medium voltage modular rack system configured in accordance with some embodiments of the present disclosure.
FIG. 2 illustrates a block diagram of an example modular rack system that is operatively coupled to an external DC bus according to embodiments of the present disclosure.
FIG. 3 illustrates a block diagram of another example modular rack system that includes an air handler according to embodiments of the present disclosure.
FIG. 4 illustrates a block diagram of another example modular rack system that includes a shared cooling system according to embodiments of the present disclosure.
FIG. 5 sets forth a flow chart illustrating an example method of interactive grid control according to embodiments of the present disclosure.
FIG. 6 sets forth a block diagram of an example computing device configured to provide interactive grid control in accordance with some embodiments of the present disclosure.

### DESCRIPTION OF EMBODIMENTS

The amount of electrical wiring required to carry low voltage electricity at high currents throughout a datacenter is greater than the amount of electrical wiring required to carry medium voltage electricity at relatively lower currents, while maintaining the same or similar power. Additionally, low voltage carried at higher currents tends to be a less efficient means of power transmission than medium voltage carried at lower currents, while maintaining the same or similar power. As datacenters continue to increase in power-consuming density, the need for power within the datacenter as a whole will also increase. Without a change to the conventional electrical distribution (low voltage, high current distribution), the amount of electrical wiring required to carry electricity throughout the datacenter, and more specifically to IT racks, will greatly increase. Such electrical wiring is expensive and consumes a large amount of physical space.

To reduce the need for such electrical wiring, the present disclosure sets forth various modular rack systems configured for medium voltage. The rack systems are described as 'modular' in that the systems may be formed of similar but separate physical components. For example, a single modular rack system may be formed of multiple different racks, where each rack may be configured for a specific type of component. For example, a modular rack may include: a rack configured to house IT equipment like servers, storage, and/or networking equipment; a rack configured to house power panel related equipment like PDUs (Power Distribution Units), power panels, and the like; a rack configured to house energy storage devices such as batteries, fuel cells, ultra-capacitor, and the like; and other racks as described below. The individual racks that make up the modular rack system may be roughly the same height and/or same width in some examples. In other examples, the racks may be of the same or similar height while being a different width. Together, the racks of the modular system may form what is referred to herein as a 'super rack.' The modular nature of such a super rack enables existing datacenters to be upgraded easily to include each of the racks of the super rack. A datacenter, for example, may be converted from conventional racks to super racks at a pace desirable to a user. A user may, for example, replace a number of racks with a super rack in phases.

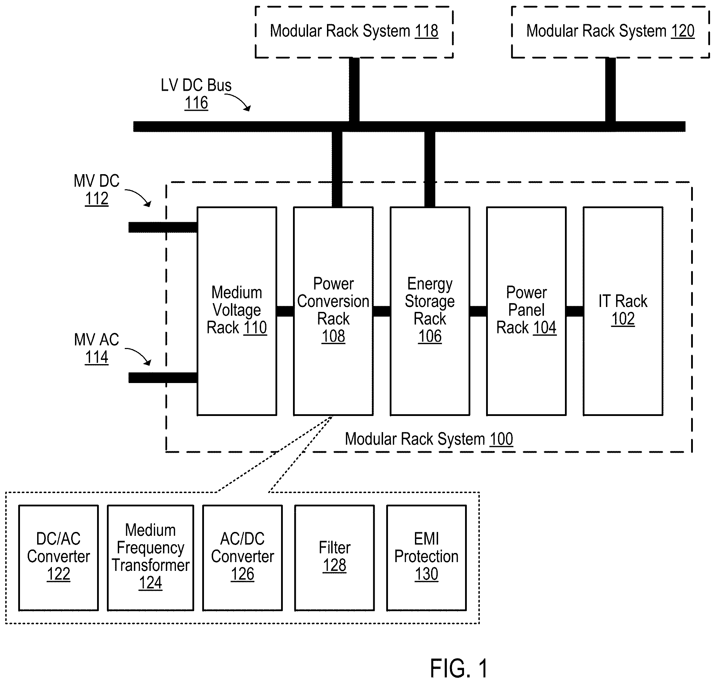

For further explanation, FIG. 1 illustrates a block diagram of an example datacenter that includes a medium voltage modular rack system configured in accordance with some embodiments of the present disclosure. The example datacenter of FIG. 1 includes a number of modular rack systems 100, 118, 120 configured for medium voltage in accordance with embodiments of the present disclosure.

In the example of FIG. 1, one of the modular rack systems 100 is depicted with a number of racks as an example while the other modular rack systems 118, 120 do not depict the racks included as part of each of the systems 118, 120. Included in the modular rack system 100 of FIG. 1 is a medium voltage rack 110. The medium voltage rack 110 of FIG. 1 is configured to receive a medium voltage DC feed 112 and/or a medium voltage AC feed 114. In some implementations, the medium voltage rack 110 may be connected at any one time to only a single one of the medium voltage feeds. Because the medium voltage rack 110 is capable of connection to either a medium voltage AC feed or a medium voltage DC feed, a modular system configured for medium voltage in accordance with embodiments of the present disclosure may be installed in any datacenter regardless of whether the datacenter is configured with medium voltage AC or medium voltage DC. Additionally, in some implementations, the medium voltage rack 110 may be coupled to both the medium voltage DC feed 112 and medium voltage AC feed 114.

The medium voltage rack 110 in the example of FIG. 1 includes one or more AC to DC converters configured convert the medium voltage AC feed 114 to medium voltage DC. The medium voltage rack 110 also includes devices to provide a passthrough of the medium voltage DC feed 112. Such devices may include wiring, connectors, busses, filters, EMI (electromagnetic interference) protection, and the like. In some examples, the medium voltage feeds may be anywhere from 1kV to 35kV.

In some embodiments, the medium voltage rack is configured for bi-directional power exchange with an electrical grid. That is, the medium voltage rack may include devices capable of providing MV AC or MV DC to an electrical grid.

The example modular rack system 100 of FIG. 1 also includes a power conversion rack 108. The power conversion rack 108 includes medium voltage conversion equipment capable of converting medium voltage DC to low voltage DC. In some embodiments, such medium voltage conversion equipment may be implemented with conventional DC to DC step-down converters. In other embodiments, the medium voltage conversion equipment of the power conversion rack may be significantly smaller in physical size in any or all of area, volume, height, weight, or width than conventional medium voltage conversion equipment in a datacenter.

Having a reduced physical size enables components of the medium voltage conversion equipment to effectively be moved from outside the datacenter, to inside the datacenter at a location close to or as part of the rack. To that end, the power conversion rack 108 may include a DC to AC converter 122 configured to output a medium frequency AC, a medium frequency AC transformer 124, and an AC to DC converter 126, a filter 128, and EMI (electromagnetic Interference) protection 130.

The example DC to AC converter 122 is configured to convert DC power to a medium frequency (e.g. in the KHZ range) AC signal. Unless stated otherwise, the term 'signal' as it used herein in relation to AC or DC, refers to an electrical transmission for power rather than a transmission of data. A DC to medium frequency AC converter can be formed of smaller components than DC to AC converters that convert the same DC signal to a lower frequency AC signal that has the same or similar power. In the example of FIG. 1, DC to a medium frequency AC converter of the power conversion rack converts, to a medium frequency AC signal, medium voltage DC from either the medium voltage DC feed 112 or the medium voltage DC generated by the conversion of the medium voltage AC feed 114 at the medium voltage rack 110.

The medium frequency AC signal generated by the DC to AC converter 122 may be provided to a medium frequency AC transformer 124. A medium frequency AC transformer is a device that is configured to receive a medium frequency AC and either step up or step down the voltage. Because of the medium frequency, the size of components required to form such an AC to AC transformer is significantly smaller than an AC to AC transformer that receives lower frequency AC signals and steps up or steps down the lower frequency AC signal. In addition, medium frequency transformers operate more efficiency than a lower frequency AC transformers. In the example of FIG. 1, the medium frequency AC transformer 124 may be configured to step down the medium frequency AC signal generated by the DC to AC converter 122 to a low voltage AC signal.

The power conversion rack 108 in the example of FIG. 1 also includes an AC to DC converter 126 that converts the low voltage AC signal generated by the medium frequency transformer to a low voltage DC signal. In some embodiments, low voltage DC can be in the range of 400-1500V.

The power conversion rack 108 may, in some embodiments, also include one or more filters 128 and EMI (electromagnetic interference) protection. The filters 128 may be any type of AC filter for power quality and conditioning, and/or a power factor correction filter. A power factor correction filter increases energy efficiency. The power factor represents the ration of 'real power' (doing useful work) to 'apparent power' (total power drawn by the load). Examples of power factor correction filters include power capacitors or capacitor banks as well as active harmonic filters, and the like.

The power conversion rack 108 provides the low voltage DC to a low voltage DC bus 116. The low voltage DC bus may be coupled to other racks within the super rack as well as other modular rack systems 118, 120 throughout the datacenter. Likewise, other modular rack systems may be coupled to the low voltage DC and provide low voltage DC to the bus. That is, modular rack systems 100, 118, 120 may all be coupled to, provide power to, and utilize power from the low voltage DC bus.

The example low voltage DC bus may be configured to be either monopolar or bipolar. A monopolar DC bus supports DC on a single conductor, where the DC has a voltage level referenced to ground. A bipolar DC bus supports two conductors, where one conductor carries DC with a positive voltage level and the other conductor carries DC with a negative voltage level of the same magnitude and the difference between the two voltages represents the total voltage carried on the bus. For example, a bipolar, low voltage DC may include a first conductor that carries DC at +400V and a second conductor that carries DC at -400V, where the total voltage carried by the DC bus is 800V.

The example modular rack system 100 of FIG. 1 also includes an energy storage rack 106. The energy storage rack 106 may include one or more energy storage devices coupled to the low voltage DC bus 116. Examples of energy storage devices include super capacitors, batteries, fuel cells, and/or the like.

The example modular rack system 100 of FIG. 1 also includes a power panel rack 104. The power panel rack 104 may include any type of power connections needed for convention conventional IT equipment. For example, the power panel rack 104 may include PDUs (power distribution units), PSUs (Power supply units) for fine control of DC voltages, UPS devices (universal power supply), and the like. In some embodiments, the power panel rack 104 may also include arc flash protection such as fuses or circuit breakers. In some embodiments, the power panel rack may include one or more solid state circuit breakers. The power panel rack 104 of FIG. 1 includes physical connection points for the coupling of power to an IT rack 102.

IT racks in a datacenter are utilized to organize and house various IT devices including, for example, compute resources like CPU-based servers and GPU-based servers, as well as networking devices, and storage devices. Racks, typically made from sturdy metal, are often tall, vertical enclosures. Such racks may be built to a standardized width, such as 19 inches, to accommodate different types of equipment in a uniform way. Each rack is divided into units, commonly called a 'U,' where 1U is 1.75 inches in height, allowing for precise configuration based on the height of the devices (number of U's) being installed. Some IT racks may be high-bay racks. A high-bay rack may be double (or greater) the height of other conventional IT racks. Such high-bay racks increase the density of power demand by enabling a greater number of power consuming devices to be installed in the same footprint as a conventional IT rack.

The example IT rack 102 in FIG. 1 may be any type of configured to house compute resources. A compute resource as the term is used here refers to any type of computer or server such as GPU or CPU-based servers. The IT rack 102 in the example of FIG. 1, in some embodiments, may also be configured to include any combination of networking devices (such as a switches and/or routers), storage devices (such as SSDs (Solid State Drives), Hard Drives, and/or RAID arrays), and the like. In some embodiments, the IT rack 102 may include only a relatively light amount of networking devices, enough, for example, to provide the minimum required connections to another racks that is configured to provide additional networking resources. Likewise, in some embodiments, the IT rack may not include any storage device but may instead include controllers capable of communicating with other racks in the datacenter that house such storage devices.

The example IT rack 102 of FIG. 1 may include power supply units, regulators, and the like to convert the low voltage from the low voltage DC bus 116 to more appropriate voltage levels for the compute resources housed within the IT rack. For example, many servers operate at 12 volts, or 48 volts DC.

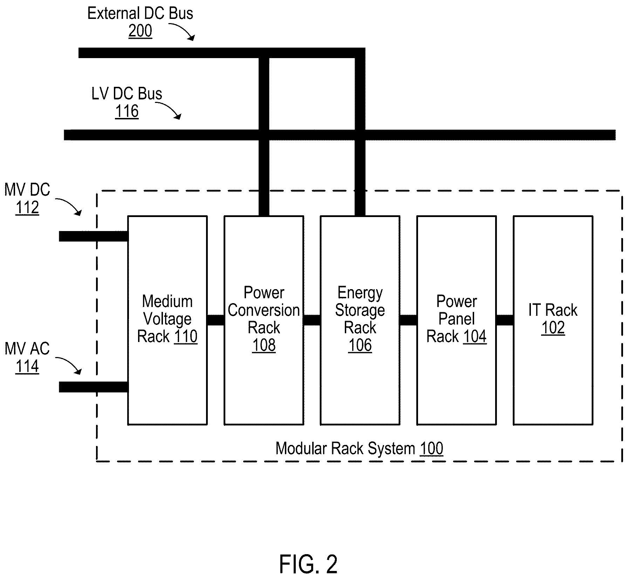

FIG. 2 illustrates a block diagram of an example modular rack system that is operatively coupled to an external DC bus according to embodiments of the present disclosure. The example modular rack system of FIG. 2 may be configured in a manner similar to the modular rack system shown in FIG. 1. The modular rack system 100 of FIG. 2, however, includes two low voltage DC busses. One of the low voltage DC busses is configured like the one depicted in FIG. 1 and is capable of being coupled to other modular rack systems 100 in the same datacenter. The second low voltage DC bus depicted in FIG. 2 is an external DC bus 200. The external DC bus may be configured to accept power for an energy storage device external to the datacenter. For example, a fuel cell, generator, battery or the like may provide power through the external DC bus 200 if either additional power is required on demand or there is a failure in the system and the low voltage DC bus is not receiving enough power from the medium voltage rack and power conversion rack of the modular rack system.

The external DC bus 200 then may be utilized as a failover in case of loss of power at the medium voltage DC feed 112 or AC feed 114. Likewise, power that would otherwise be wasted may be utilized to charge an external battery through the external DC bus.

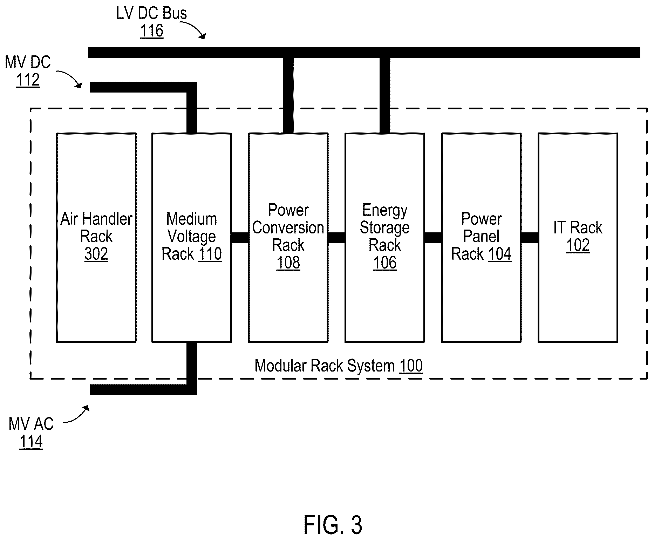

FIG. 3 illustrates a block diagram of another example modular rack system that includes an air handler according to embodiments of the present disclosure. The modular rack system 100 of FIG. 3 is similar to that of FIG. 1 except that the modular rack system also includes an air handler rack 302. An air handler in a datacenter, sometimes referred to as a computer room air handler (CRAH), is a device that cools the air and maintains the temperature and humidity levels. An air handler may utilize fans, cooling coils, liquid chiller systems, and the like to remove heat from the air.

In a manner analogous to the effective 'moving' of medium voltage from outside of the data to the rack, the air handler rack 302 enables localized cooling at the rack. By contrast, conventional datacenters tend to have predefined spaces, rooms, or even small buildings dedicated for cooling systems. By localizing the cooling of the IT modular rack system to the rack itself, the cooling systems of a datacenter may effectively be 'moved' to the rack from their conventional locations in the datacenter.

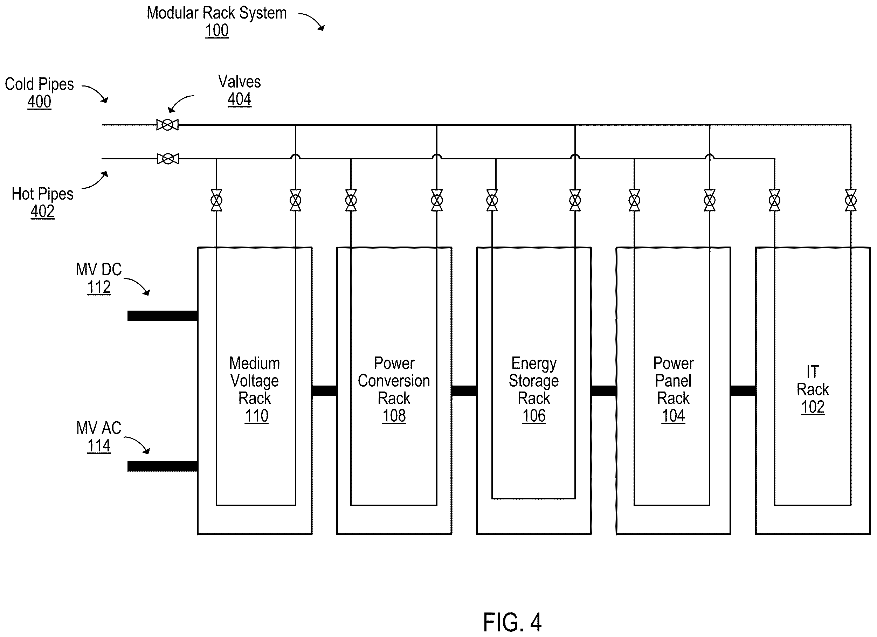

FIG. 4 illustrates a block diagram of another example modular rack system that includes a shared cooling system according to embodiments of the present disclosure. The example modular rack system of FIG. 4 is similar to that of FIG. 1. The example modular rack system of FIG. 4, however, includes a shared cooling system that includes cold pipes 400, hot pipes 402, and valves 404. Cold pipes carry coolant to each rack. Heat is removed from the racks by transferring the heat to the coolant, and the heated coolant is carried away from the racks in the hot pipes.

In some embodiments, the valves may be selectively controllable to provide targeted cooling to the racks of the modular rack system. That is, the valves may be opened to allow additional coolant flow or closed to restrict coolant flow based on need. Such control may be dynamic, based on current temperatures within each of the racks, or predefined by a system administrator.

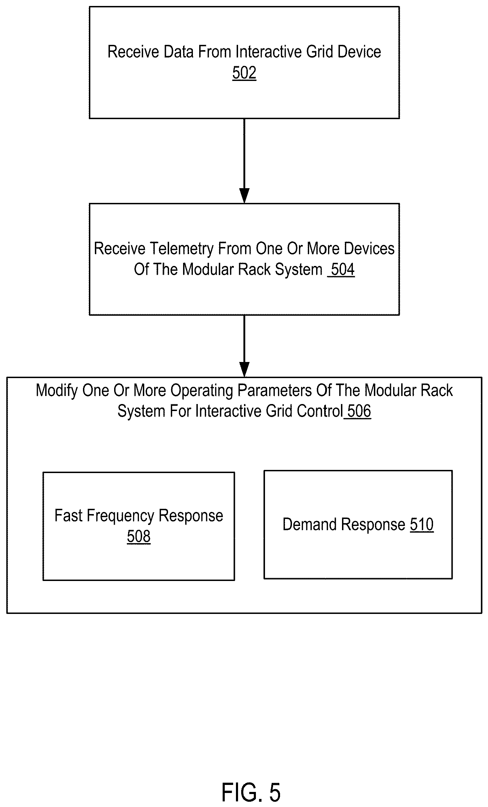

For further explanation, FIG. 5 sets forth a flow chart illustrating an example method of interactive grid control according to embodiments of the present disclosure. The example method of FIG. 5 may be carried out by a control system associated with one or more medium voltage modular rack systems like those described above. Such a control system may be formed of a number of agents, hardware and software, distributed throughout the modular rack systems as well as a processing devices and memory in the form of a computer system.

Power systems configured for grid interaction enable two-way communication between the power system and devices at the electrical grid. In the example of FIG. 5, a medium voltage modular rack system may be configured to receive 502 or data from an interactive grid device and may also receive 504 telemetry from devices within the modular rack system. The data received form the interactive grid device may indicate a variety of parameters, such as, for example, the present demand on the electrical grid. The telemetry from the devices within the modular rack system may provide data such as the present power demand from devices within the rack system, temperatures within the rack system, energy storage levels, and the like.

Based on the data from the interactive grid device and the telemetry of the devices within the modular rack system, the method of FIG. 5 continues by modifying 506 one or more operating parameters of the modular rack system to address the data received from the interactive grid device. In some examples, modifying the parameters for interactive grid control may include performing a FFR (Fast Frequency Response) 508. FFR is performed by rapidly adjusting power output or load to quickly stabilize grid frequency when there is a sudden imbalance between supply and demand. This essentially acts as a quick response mechanism to prevent large frequency fluctuations and potential power disruptions at the grid level. This is often achieved through technologies like battery storage or inverter-based renewable energy sources that can react very fast to changes in grid frequency. In the example of FIG. 5, the modular rack system may alter the load or provide additional power via energy storage devices back to the grid when the need arises.

In some examples, the parameters for interactive grid control may be modified in order to perform a demand response 510. Demand response is a means by which a power customer (the data center or modular rack systems in this example) utilizes data provided by the interactive grid device to determine when to reduce or shift electricity usage. For example, the interactive grid device may inform end users of peak demand periods and cost of electricity during those periods. The interactive grid controller of the modular rack system may utilize that information to rely more heavily previously stored energy storage during peak demand periods or reduce load during those periods, or both. The controller may selectively power off compute devices in the IT rack to reduce load, or control power conversions to reduce load on the electrical grid.

Although FFR and demand responses are described here, readers will understand that other types of grid control may also include other ancillary services. For example, the interactive grid control may also provide frequency regulation, spinning reserve, voltage regulation, and like.

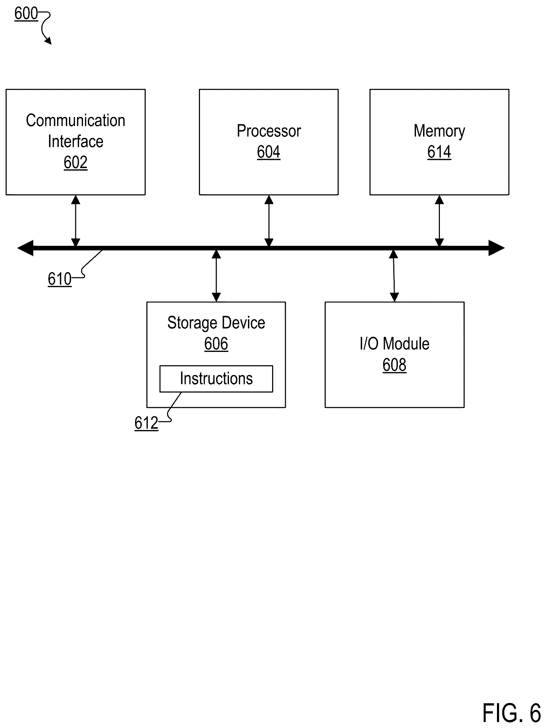

For further explanation, FIG. 6 illustrates an exemplary computing device 600 that may be specifically configured to perform one or more of the processes described herein. More specifically, the example computing device 600 in FIG. 6 may operate to administer operations of a medium voltage modular rack system for grid interaction in accordance with the methods described above. As shown in FIG. 6, computing device 600 may include a communication interface 602, a processor 604, a storage device 606, an input/output (I/O) module 608, and computer memory 614 communicatively connected one to another via a communication infrastructure 610. While an exemplary computing device 600 is shown in FIG. 6, the components illustrated in FIG. 6 are not intended to be limiting. Additional or alternative components may be used in other embodiments. Components of computing device 600 shown in FIG. 6 will now be described in additional detail.

Communication interface 602 may be configured to communicate with one or more computing devices. Examples of communication interface 602 include, without limitation, a wired network interface (such as a network interface card), a wireless network interface (such as a wireless network interface card), a modem, an audio/video connection, and any other suitable interface.

Processor 604 generally represents any type or form of processing unit capable of processing data and/or interpreting, executing, and/or directing execution of one or more of the instructions, processes, and/or operations described herein. Processor 604 may perform operations by executing computer-executable instructions 612 (e.g., an application, software, code, and/or other executable data instance) stored in storage device 606.

Storage device 606 may include one or more data storage media, devices, or configurations and may employ any type, form, and combination of data storage media and/or device. For example, storage device 606 may include, but is not limited to, any combination of non-volatile media and/or volatile media. Electronic data, including data described herein, may be temporarily and/or permanently stored in storage device 606. For example, data representative of computer-executable instructions 612 configured to direct processor 604 to perform any of the operations described herein may be stored within storage device 606. In some examples, data may be arranged in one or more databases residing within storage device 606.

I/O module 608 may include one or more I/O modules configured to receive user input and provide user output. I/O module 608 may include any hardware, firmware, software, or combination thereof supportive of input and output capabilities. For example, I/O module 608 may include hardware and/or software for capturing user input, including, but not limited to, a keyboard or keypad, a touchscreen component (e.g., touchscreen display), a receiver (e.g., an RF or infrared receiver), motion sensors, and/or one or more input buttons.

I/O module 608 may include one or more devices for presenting output to a user, including, but not limited to, a graphics engine, a display (e.g., a display screen), one or more output drivers (e.g., display drivers), one or more audio speakers, and one or more audio drivers. In certain embodiments, I/O module 608 is configured to provide graphical data to a display for presentation to a user. The graphical data may be representative of one or more graphical user interfaces and/or any other graphical content as may serve a particular implementation. In some examples, any of the systems, computing devices, and/or other components described herein may be implemented by computing device 600.

Advantages and features of the present disclosure can be further described by the following clauses:
Clause 1. A modular rack system, comprising: an IT (Information Technology) rack configured to house a plurality of compute resources; a power panel rack comprising a plurality of power connectors and configured to operatively couple the compute resources to a low voltage DC (Direct Current) power source; an energy storage rack comprising one or more energy storage devices, wherein each of the energy storage devices is configured to store energy from and provide energy to the low voltage DC power source; a power conversion rack comprising power conversion devices configured to convert a medium voltage power source to the low voltage DC source; and a medium voltage rack configured to receive a medium voltage AC (Alternating Current) source and/or a medium voltage DC source.
Clause 2. The modular rack system of clause 1, wherein the power conversion rack is configured to be coupled to a low voltage DC bus, wherein the low voltage DC bus is configured to be coupled to other modular rack systems.
Clause 3. The modular rack system of any combination of clause 1 or 2, wherein the power conversion rack is configured to be coupled to a second low voltage DC bus, wherein the second low voltage DC bus is configured to be coupled to other components in a datacenter.
Clause 4. The modular rack system of any combination of clause 1, 2 or 3, wherein the energy storage devices are configured to be coupled to the low voltage DC bus.
Clause 5. The modular rack system of any combination of clause 1, 2, 3, or 4, wherein the medium voltage rack is configured for bi-direction power exchange with an electrical grid.
Clause 6. The modular rack system of any combination of clause 1, 2, 3, 4, or 5, further comprising a shared cooling system.
Clause 7. The modular rack system of any combination of clause 1, 2, 3, 4, 5, or 6, wherein the shared cooling system comprises a plurality of valves selectively controllable to provide targeted cooling to the racks of the modular rack system.
Clause 8. The modular rack system of any combination of clause 1, 2, 3, 4, 5, 6, or 7, further comprising an air-handler rack configured to provide localized cooling to the modular rack system and comprising one or more devices to remove heat from air.
Clause 9. The modular rack system of any combination of clause 1, 2, 3, 4, 5, 6, 7, or 8, wherein the power conversion rack further comprises: a DC to AC converter; a medium frequency AC transformer; and an AC to DC converter.
Clause 10. The modular rack system of any combination of clause 1, 2, 3, 4, 5, 6, 7, 8, or 9, wherein the power conversion rack further comprises: a filter comprising one of: an AC filter or a power factor correction filter; and EMI (electromagnetic Interference) protection.
Clause 11. The modular rack system of any combination of clause 1, 2, 3, 4, 5, 6, 7, 8, 9, or 10, wherein the medium voltage rack further comprises an AC to DC converter for converting medium voltage AC to medium voltage DC.
Clause 12. The modular rack system of any combination of clause 1, 2, 3, 4, 5, 6, 7, 8, 9, 10, or 11, wherein the power panel rack comprises arc flash protection and one or more solid state circuit breakers.
Clause 13. The modular rack system of any combination of clause 1, 2, 3, 4, 5, 6, 7, 8, 9, 10, 11, or 12, wherein the racks of the modular rack system are located on a same level of a datacenter floor.
Clause 14. The modular rack system of any combination of clause 1, 2, 3, 4, 5, 6, 7, 8, 9, 10, 11, 12, or 13, wherein one or more of the racks are located on a platform above others of the racks.
Clause 15. An apparatus for administering operations of a modular rack system for grid interaction, the apparatus comprising: one or more processing devices; and one or more memory devices operatively coupled to the processing devices, where the processing devices are configured to: modify one or more operating parameters of the modular rack system for interactive grid control, wherein the modular rack system comprises an IT (Information Technology) rack housing a plurality of compute resources, a power panel rack comprising a plurality of power connectors operatively coupling the compute resources to a low voltage DC (Direct Current) power source; a power conversion rack comprising power conversion devices configured to convert a medium voltage power source to a low voltage DC source; and a medium voltage rack configured to receive a medium voltage AC source and a medium voltage DC source.
Clause 16. The apparatus of clause 15, wherein the one or more processing devices are further configured to modify one or more operating parameters of the modular rack system to support one of: FFR (Fast Frequency Response), demand response, frequency regulation, spinning reserves, voltage regulation and the like.
Clause 17, The apparatus of any combination of clause 15 or 16, wherein the one or more processing devices are further configured to control energy storage coupled to the modular rack system to provide power to the electrical grid.
Clause 18. The apparatus of any combination of clause 15, 16, or 17, wherein the one or more processing devices are further configured to selectively power off compute devices of the IT rack.
Clause 19. The apparatus of any combination of clause 15, 16, 17, or 18, wherein the one or more processing devices are further configured to control power conversion at the modular rack system.
Clause 20. A method of administering operations of a modular rack system for grid interaction, the method comprising receiving data from an interactive grid device; and receiving telemetry from one or more devices of the modular rack system; and modifying one or more operating parameters of the modular rack system for interactive grid control based on the telemetry and the one or more requests, wherein the modular rack system comprises an IT (Information Technology) rack housing a plurality of compute resources, a power panel rack comprising a plurality of power connectors operatively coupling the compute resources to a low voltage DC (Direct Current) power source; a power conversion rack comprising power conversion devices configured to convert a medium voltage power source to a low voltage DC source; and a medium voltage rack configured to receive a medium voltage AC source and a medium voltage DC source.
Clause 20A. A method of administering operations of a modular rack system for grid interaction, the method comprising receiving data from an interactive grid device; and receiving telemetry from one or more devices of the modular rack system; and modifying one or more operating parameters of the modular rack system for interactive grid control based on the telemetry and the data, wherein the modular rack system comprises an IT (Information Technology) rack housing a plurality of compute resources, a power panel rack comprising a plurality of power connectors operatively coupling the compute resources to a low voltage DC (Direct Current) power source; a power conversion rack comprising power conversion devices configured to convert a medium voltage power source to a low voltage DC source; and a medium voltage rack configured to receive a medium voltage AC source and a medium voltage DC source.

Although some embodiments are described largely in the context of a system, method, or in some other way, readers will recognize that embodiments of the present disclosure may also take the form of a computer program product disposed upon computer readable storage media for use with any suitable processing system. Such computer readable storage media may be any storage medium for machine-readable information, including magnetic media, optical media, solid-state media, or other suitable media. Examples of such media include magnetic disks in hard drives or diskettes, compact disks for optical drives, magnetic tape, and others as will occur to those of skill in the art. Persons skilled in the art will immediately recognize that any computer system having suitable programming means will be capable of executing the steps described herein as embodied in a computer program product. Persons skilled in the art will recognize also that, although some of the embodiments described in this specification are oriented to software installed and executing on computer hardware, nevertheless, alternative embodiments implemented as firmware or as hardware are well within the scope of the present disclosure.

Readers will appreciate that some embodiments are described in which computer program instructions are executed on computer hardware such as, for example, one or more computer processors. Readers will appreciate that in other embodiments, computer program instructions may be executed on virtualized computer hardware (e.g., one or more virtual machines), in one or more containers, in one or more cloud computing instances (e.g., one or more AWS EC2 instances), in one or more serverless compute instances offered such as those offered by a cloud services provider, in one or more event-driven compute services such as those offered by a cloud services provider, or in some other execution environment.

In some examples, a non-transitory computer-readable medium storing computer-readable instructions may be provided in accordance with the principles described herein. The instructions, when executed by a processor of a computing device, may direct the processor and/or computing device to perform one or more operations, including one or more of the operations described herein. Such instructions may be stored and/or transmitted using any of a variety of known computer-readable media.

A non-transitory computer-readable medium as referred to herein may include any non-transitory storage medium that participates in providing data (e.g., instructions) that may be read and/or executed by a computing device (e.g., by a processor of a computing device). For example, a non-transitory computer-readable medium may include, but is not limited to, any combination of non-volatile storage media and/or volatile storage media. Exemplary non-volatile storage media include, but are not limited to, read-only memory, flash memory, a solid-state drive, a magnetic storage device (e.g., a hard disk, a floppy disk, magnetic tape, etc.), ferroelectric random-access memory (RAM), and an optical disc (e.g., a compact disc, a digital video disc, a Blu-ray disc, etc.). Exemplary volatile storage media include, but are not limited to, RAM (e.g., dynamic RAM).

One or more embodiments may be described herein with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope of the claims. Further, the boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality.

To the extent used, the flow diagram block boundaries and sequence could have been defined otherwise and still perform the certain significant functionality. Such alternate definitions of both functional building blocks and flow diagram blocks and sequences are thus within the scope of the claims. One of average skill in the art will also recognize that the functional building blocks, and other illustrative blocks, modules and components herein, can be implemented as illustrated or by discrete components, application specific integrated circuits, processors executing appropriate software and the like or any combination thereof.

While particular combinations of various functions and features of the one or more embodiments are expressly described herein, other combinations of these features and functions are likewise possible. The present disclosure is not limited by the particular examples disclosed herein and expressly incorporates these other combinations.

## Claims

1. A modular rack system, comprising:
an IT, Information Technology, rack (102) configured to house a plurality of compute resources;
a power panel rack (104) comprising a plurality of power connectors and configured to operatively couple the compute resources to a low voltage DC, Direct Current, power source (116);
an energy storage rack (106) comprising one or more energy storage devices, wherein each of the energy storage devices is configured to store energy from and provide energy to the low voltage DC power source (116);
a power conversion rack (108) comprising power conversion devices configured to convert a medium voltage power source to the low voltage DC source (116); and
a medium voltage rack (110) to receive a medium voltage AC, Alternating Current, source (114) and a medium voltage DC source (112).

2. The modular rack system of claim 1, wherein the power conversion rack is configured to be coupled to a low voltage DC bus, wherein the low voltage DC bus is configured to be coupled to other modular rack systems.

3. The modular rack system of claim 2, wherein the power conversion rack is configured to be coupled to a second low voltage DC bus, wherein the second low voltage DC bus is configured to be coupled to other components in a datacenter.

4. The modular rack system of claim 2, wherein the energy storage devices are configured to be coupled to the low voltage DC bus.

5. The modular rack system of any preceding claim, wherein the medium voltage rack is configured for bi-direction power exchange with an electrical grid.

6. The modular rack system of any preceding claim, further comprising a shared cooling system.

7. The modular rack system of claim 6, wherein the shared cooling system comprises a plurality of valves selectively controllable to provide targeted cooling to the racks of the modular rack system.

8. The modular rack system of any preceding claim, further comprising an air-handler rack configured to provide localized cooling to the modular rack system and comprising one or more devices to remove heat from air.

9. The modular rack system of any preceding claim, wherein the power conversion rack further comprises:
a DC to AC converter;
a medium frequency AC transformer; and
an AC to DC converter.

10. The modular rack system of any preceding claim, wherein the power conversion rack further comprises:
a filter comprising one of: an AC filter or a power factor correction filter; and
EMI, electromagnetic Interference, protection.

11. The modular rack system of any preceding claim, wherein the medium voltage rack further comprises an AC to DC converter for converting medium voltage AC to medium voltage DC.

12. The modular rack system of any preceding claim, wherein the power panel rack comprises arc flash protection and one or more solid state circuit breakers.

13. An apparatus for administering operations of a modular rack system for grid interaction, the apparatus comprising:
one or more processing devices (604); and
one or more memory devices (614) operatively coupled to the processing devices, where the processing devices (604) are configured to:
modify (506) one or more operating parameters of the modular rack system (100) for interactive grid control, wherein the modular rack system (100) comprises an IT, Information Technology, rack (102) housing a plurality of compute resources, a power panel rack (104) comprising a plurality of power connectors operatively coupling the compute resources to a low voltage DC, Direct Current, power source; a power conversion rack (108) comprising power conversion devices configured to convert a medium voltage power source to a low voltage DC source; and a medium voltage rack (110) configured to receive a medium voltage AC source (114) and a medium voltage DC source (112).

14. The apparatus of claim 13 wherein the one or more processing devices are further configured to modify one or more operating parameters of the modular rack system to support one of: FFR, Fast Frequency Response; demand response; frequency regulation; spinning reserves and voltage regulation.

15. A method of administering operations of a modular rack system for grid interaction, the method comprising
receiving (502) data from an interactive grid device; and
receiving (504) telemetry from one or more devices of the modular rack system; and
modifying (506) one or more operating parameters of the modular rack system for interactive grid control based on the telemetry and the data, wherein the modular rack system (100) comprises an IT, Information Technology, rack (102) housing a plurality of compute resources, a power panel rack (104) comprising a plurality of power connectors operatively coupling the compute resources to a low voltage DC, Direct Current, power source (116); a power conversion rack (108) comprising power conversion devices configured to convert a medium voltage power source to a low voltage DC source (116); and a medium voltage rack (110) configured to receive a medium voltage AC (114) source and a medium voltage DC source (112).
